# DEMANDE DE BREVET EUROPEEN

(11) **EP 0 930 652 A1**
(43) Date de publication de la demande: **21.07.1999**
(21) Numéro de dépôt: 98403095.7
(22) Date de dépôt: 09.12.1998
(51) Int. Cl.: H01L 23/528, H01L 23/538

(54) **Portion de métallisation de circuit intégré**

(30) Priorité: 30.12.1997 FR 9716654
(71) Demandeur: STMicroelectronics SA, 94250 Gentilly Cedex (FR); FRANCE TELECOM, 75015 Paris (FR)
(72) Inventeur: Gayet, Philippe, 38660 St. Vincent de Mercuze (FR); Brunel, Chantal, 38660 La Terrasse (FR); Martin, Stéphane, 38000 Grenoble (FR)
(74) Mandataire: Casalonga, Axel

(57) **Abrégé**

Portion de circuit intégré comprenant une pluralité de niveaux de métallisation séparés par des couches diélectriques, chaque niveau de métallisation étant pourvu de pistes 20, et des vias métallisés 24, 25 connectant des pistes de deux niveaux de métallisation inférieur et supérieur. Toute portion de piste 21, 22 connectée à un via 24, 25 s'étend dans une direction unique pour un niveau donné de métallisation sur une distance minimale prédéterminée à partir du dit via 24, 25.

## Description

La présente invention concerne le domaine des circuits intégrés à plusieurs niveaux de métallisation séparés par des couches diélectriques et peut s'appliquer à un circuit intégré complet, à une portion de circuit intégré ou encore à une structure de test adjacente à un circuit intégré et fabriquée sur la même tranche de silicium.

Dans les circuits intégrés, les différents niveaux de métallisation sont séparés par des couches diélectriques réalisées par exemple à base d'oxyde de silicium SiOₓ. Chaque niveau de métallisation est pourvu de pistes électriquement conductrices et des vias métallisés sont prévus pour connecter des pistes des niveaux de métallisation inférieur et supérieur.

Sur le bord d'un circuit intégré proprement dit, sur la même tranche de silicium, on implémente, en général, une structure de test qui consiste en une pluralité de segments de pistes à un niveau de métallisation n, un nombre égal de segments de pistes au niveau de métallisation n+1 et des vias reliant l'extrémité d'un segment de piste du niveau de métallisation n à la première extrémité d'un segment de piste du niveau n+1, et la deuxième extrémité du segment de piste du niveau de métallisation n+1 à une première extrémité d'un autre segment de piste du niveau n et ainsi de suite, chaque segment de piste d'un niveau de métallisation donné étant relié par deux vias à deux autres segments de pistes de l'autre niveau de métallisation. Une telle structure de test permet de connaître la résistance électrique d'un via en mesurant la résistance électrique offerte par la structure de test et en la divisant par le nombre de vias de ladite structure de test.

De façon connue, les pistes des différents niveaux de métallisation sont de largeur supérieure à la largeur d'un via. Le contact entre un via et un segment de piste s'effectue donc sur une surface de contact constante correspondant à la section d'un via même en cas de décalage dans un plan horizontal entre un via et le segment de piste avec lequel il est en contact.

Le décalage est la conséquence de manque de précision des équipements de définition des motifs (photolithographie) pour aligner un niveau par rapport aux précédents. Tant que le recouvrement des pistes par rapport aux vias est supérieur au décalage maximal, la surface de contact reste constante en fonction des décalages.

Toutefois, on cherche à utiliser des pistes de largeur réduite afin de diminuer la taille des circuits semi-conducteurs. Lorsqu'on utilise des pistes de largeur sensiblement égale à celle d'un via, le moindre décalage entre la piste et le via se traduit par une diminution de la surface de contact entre la piste et le via et par une augmentation de la résistance de ce contact. De plus, en fonction de la position des vias par rapport aux pistes, les surfaces de contact sont différentes d'un via à l'autre, le calcul de la résistance d'un via grâce à une structure de test ne donne qu'une valeur moyenne pouvant cacher les disparités importantes d'un via à l'autre. Dans un circuit intégré proprement dit, la dispersion des valeurs de résistance de vias est susceptible de dégrader les performances des circuits et de conduire à la mise au rebut de certains d'entre eux.

La présente invention a pour objet de remédier aux inconvénients évoqués ci-dessus, en proposant un circuit intégré ou une portion de circuit intégré dont la largeur des pistes est sensiblement égale à la largeur des vias et permettant de contrôler la valeur de la résistance des vias.

La portion de circuit intégré selon l'invention comprend une pluralité de niveaux de métallisation séparés par des couches diélectriques, chaque niveau de métallisation étant pourvu de pistes, et des moyens de connexion connectant des pistes de deux niveaux de métallisation inférieur et supérieur. Toute portion de piste connectée à des moyens de connexion s'étend dans une direction unique pour un niveau donné de métallisation sur une distance prédéterminée à partir de la connexion, de façon qu'un éventuel défaut d'alignement entre les pistes d'un niveau de métallisation et les moyens de connexion desdites pistes produise une modification sensiblement constante de la résistance existant entre une piste et les moyens de connexion sur tout ledit niveau de métallisation.

De préférence, les moyens de connexion comprennent des vias métallisés.

Ainsi, dans le cas d'un défaut d'alignement entre les pistes d'un niveau de métallisation et les vias correspondants ou entre les vias et les pistes correspondantes, les surfaces de contact entre lesdites pistes et lesdits vias sont modifiées d'une façon relativement constante d'une surface de contact à l'autre par rapport aux surfaces de contact normales en l'absence de défaut d'alignement.

Dans un mode de réalisation de l'invention, la distance minimale prédéterminée est sensiblement égale à la somme de la largeur d'un via et du décalage maximum entre les pistes et les vias, ce décalage étant dû à l'imprécision des équipements de définition des motifs, la largeur étant prise dans un plan parallèle aux plans des niveaux de métallisation.

Avantageusement, toute portion de piste connectée à un via s'étend dans un sens unique pour un niveau donné de métallisation de façon qu'un éventuel défaut d'alignement entre les pistes d'un niveau de métallisation et les vias connectés auxdites pistes produise une modification constante de la résistance existant entre une piste et un via sur tout ledit niveau de métallisation.

Dans un mode de réalisation de l'invention, seules les extrémités des pistes sont orientées.

Dans un mode de réalisation de l'invention, la largeur d'une piste est inférieure ou égale à la somme de la largeur d'un via et du décalage maximal entre les pistes et les vias. La largeur d'une piste peut être égale à la largeur d'un via.

L'invention a également pour objet une structure de test comportant une portion de circuit tel que décrit précédemment, et un circuit intégré comprenant une telle structure de test.

L'invention a également pour objet un circuit intégré comportant une portion de circuit tel que décrit précédemment.

Ainsi, toutes les pistes d'un niveau de métallisation donné connectées à des vias, comprennent des portions de pistes connectées auxdits vias et toutes orientées dans une direction unique et de préférence dans un sens unique. En d'autres termes, l'accès d'une piste à un via s'effectue pour un niveau de métallisation donné toujours du même côté du via.

Un éventuel décalage entre les vias et les pistes qui est constant pour un niveau de métallisation donné, se traduit alors par une modification de la surface de contact entre vias et pistes, constante pour tout ledit niveau de métallisation et par conséquent par une modification toujours constante pour le même niveau de métallisation des résistances de vias. Cette caractéristique est intéressante dans une structure de test du circuit intégré, car elle permet un calcul précis de la résistance de via. Elle est également intéressante dans le cas d'un circuit intégré complet car elle limite la dispersion des valeurs de résistance des vias qui est susceptible d'affecter le fonctionnement du circuit intégré, voire même de conduire à sa mise au rebut. Elle contribue donc à l'amélioration de la qualité des circuits intégrés et à la réduction du taux de défauts.

La présente invention sera mieux comprise et d'autres avantages apparaîtront à la lecture de la description détaillée d'un mode de réalisation pris à titre d'exemple nullement limitatif et illustré par les dessins annexés, sur lesquels :
la figure 1 est une vue schématique de côté d'un circuit intégré selon l'art antérieur;
les figures 2a à 2i sont des vues schématiques de dessus du circuit intégré de la figure 1; et
les figures 3a à 3i sont des vues schématiques de dessus d'une portion de circuit intégré conforme à l'invention.

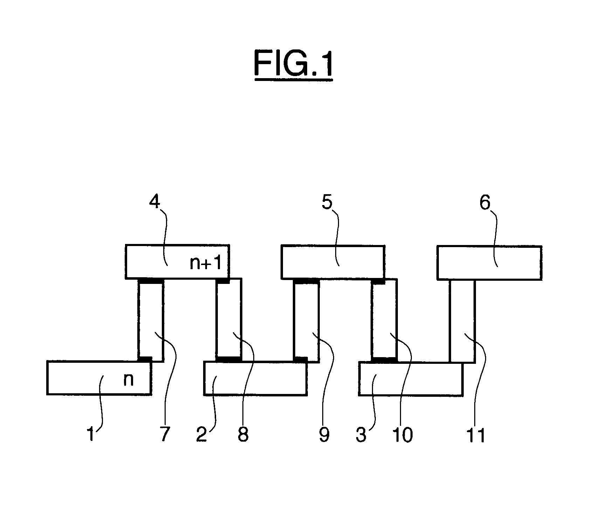

Comme on peut le voir sur la figure 1, les pistes 1, 2 et 3 du niveau de métallisation n d'un circuit intégré sont connectées électriquement aux pistes 4, 5 et 6 du niveau de métallisation supérieur n+1 par des vias métallisés 7 à 11 qui traversent une couche diélectrique non représentée disposée entre les niveaux de métallisation n et n+1. Les pistes 1 à 3 et 4 à 6 sont de largeur égale aux vias 7 à 11. Toutefois, lors de la définition (photolithogravure) des trous dans lesquels sont disposés les vias 7 à 11, un léger décalage s'est produit. Il en résulte que les vias 7 à 11 ne sont pas parfaitement alignés avec les pistes 1 à 3 et que les surfaces de contact entre les vias 7 à 11 et les pistes 1 à 3 sont inférieures à la surface de la section d'un via, mais l'on ne connaît pas de façon précise la valeur de ces surfaces de contact qui n'est pas la même d'un via à l'autre et par conséquent la valeur des résistances de vias. Il en est de même pour la définition des pistes 4 à 6 du niveau n+1 sur les vias 7 à 11 (le décalage peut être différent entre la réalisation des vias sur le niveau n et la réalisation du niveau n+1 sur les vias).

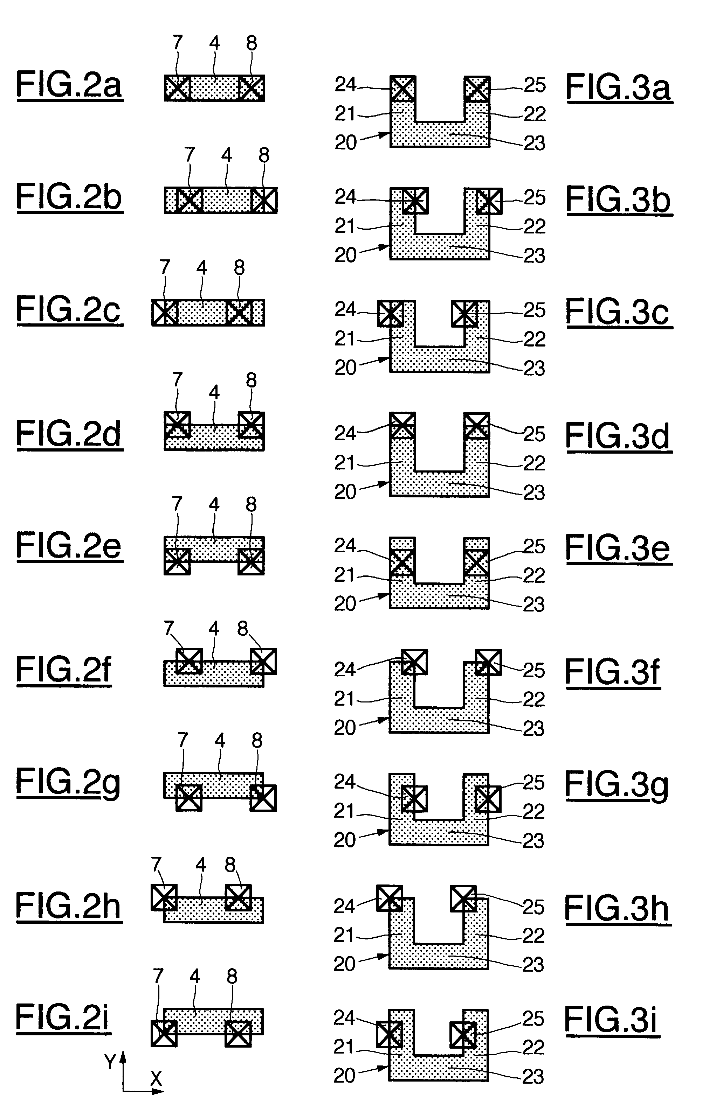

En effet, comme on peut le voir sur les figures 2a à 2i, le décalage entre les vias et les pistes peut se produire selon des directions quelconques dans le plan horizontal X-Y, ce qui entraîne des surfaces de contact différentes. Sur la figure 2a, le cas idéal est représenté où les vias 7 et 8 sont parfaitement alignés avec la piste 4.

En figure 2b, le décalage s'est produit selon l'axe X dans une direction donnée. Sur la figure 2c, le sens du décalage est opposé à celui de la figure 2b. Sur la figure 2d, le décalage s'est produit dans un sens selon l'axe Y. Sur la figure 2e, le décalage s'est produit selon l'axe Y dans le sens opposé à celui de la figure 2d. Sur la figure 2f, le décalage s'est produit selon les deux axes X et Y dans deux sens donnés. Sur la figure 2g, le décalage s'est produit selon les deux axes X et Y, sur l'axe Y dans le sens opposé au décalage de la figure 2f. Sur la figure 2h, le décalage s'est produit selon les deux axes X et Y, selon l'axe X dans le sens opposé à celui de la figure 2f. Sur la figure 2i, le décalage s'est produit selon les deux axes X et Y, sur chaque axe dans le sens opposé à celui de la figure 2f.

On voit que sur les figures 2d et 2e, la surface de contact entre le via 7 et la piste 4 est égale à la surface de contact entre le via 8 et la piste 4. Toutefois, cela n'est vrai qu'à titre d'exemple, dans un circuit les pistes peuvent être horizontales ou verticales. Au contraire, dans les autres cas de décalage, on remarque que les surfaces de contact entre, d'une part le via 7 et la piste 4 et, d'autre part, le via 8 et la piste 4, sont à chaque fois différentes. On ne peut donc pas calculer de façon précise la valeur d'une résistance de via, ce qui peut nuire aux performances d'un circuit intégré.

Une portion de circuit intégré conforme à l'invention est représentée sur les figures 3a à 3i. La piste 20 d'un niveau donné de métallisation est reliée à deux vias 24 et 25, qui peuvent être disposés vers un même niveau de métallisation supérieur ou inférieur ou vers, l'un le niveau de métallisation inférieur et l'autre, le niveau de métallisation supérieur. La piste 20 comprend une portion de piste 21 adjacente au via 24, une portion de piste 22 adjacente au via 25 et une portion de liaison 23. La forme de la portion de liaison 23 est donnée ici à titre purement indicatif mais sera, en général, considérablement plus compliquée dans un circuit complet.

Les portions 21 et 22 sont disposées à partir des vias correspondants 24 et 25 selon une direction et un sens communs pour toutes les portions de pistes adjacentes à des vias sur ce niveau de métallisation. La longueur des portions 21 et 22 est sensiblement supérieure à la largeur d'un via 24, 25, pour éviter que la portion de liaison 23 ne se trouve trop proche d'un des vias 24, 25 et, en cas de décalage, ne participe à la surface de contact entre la piste 20 et l'un des vias 24, 25. On choisit de préférence une longueur minimale des portions 21 et 22 égale à la largeur d'un via plus le décalage maximum dû au manque de précision d'alignement des équipements de réalisation des circuits.

Comme on peut le voir sur les figures 3b à 3i, quels que soient la direction et le sens du décalage entre la piste 20 et les vias 24 et 25, les surfaces de contact, c'est-à-dire les surfaces communes à la piste 20 et aux vias 24 et 25, sont égales pour chacun des vias 24 et 25. En généralisant, on voit donc que sur toutes portions de circuits intégrés construites conformément à l'invention, un décalage éventuel entre les pistes d'un niveau de métallisation et les vias auxquels elles sont connectées, se traduit par une modification uniforme des résistances de vias pour ce niveau de métallisation.

Dans le cas d'une structure de test, on peut mesurer la résistance totale offerte par l'enchaînement d'un nombre donné de vias et de portions de pistes, puis diviser cette valeur par le nombre de vias pour obtenir la valeur de la résistance d'un via qui, par construction, est uniforme pour cette structure de test. Il en va de même pour un circuit intégré dans son ensemble où l'on pourra limiter la dispersion des résistances de via et connaître la résistance de via, donc éviter de rejeter lors des contrôles de qualité des circuits intégrés ayant subi des décalages relativement importants entre vias et pistes, ces décalages importants étant rendus supportables par le fait que les résistances de vias sont uniformes et connues.

Sur les figures 3a à 3i, on a représenté un mode de réalisation où les portions de pistes adjacentes aux vias s'étendent selon une direction et un sens communs. Toutefois, une telle structure peut s'avérer contraignante au niveau du dessin des pistes d'un circuit complexe. En variante, on peut donc permettre, tout en restant dans le cadre de l'invention, que les portions de pistes adjacentes aux vias soient, pour un niveau de métallisation donné, orientées selon une direction commune mais selon deux sens opposés. Il peut en résulter une légère dégradation de l'uniformité de la valeur des résistances de vias, mais en contrepartie, le dessin des pistes d'un niveau de métallisation peut dans certaines applications s'en trouver facilité. On peut ainsi, connecter un via au milieu d'une portion rectiligne de piste, la piste s'étendant sur deux côtés opposés du via.

Il peut être également avantageux de traiter selon l'invention uniquement les extrémités des pistes.

Grâce à l'invention, on dispose d'une portion de circuit intégré, d'une structure de test ou d'un circuit intégré complet dont on peut déterminer précisément la valeur de la résistance des vias, ce qui facilite l'utilisation de pistes de faible largeur et évite la dégradation des performances des circuits intégrés en raison des décalages inhérents aux étapes de réalisation.

Bien entendu, l'invention s'applique à tous types de conducteurs utilisés, y compris les prises de contacts sur substrat de silicium ou tout autre matériau semi-conducteur, ainsi qu'à tous types de diélectriques utilisés.

L'invention s'applique à tous les choix d'orientation sur un substrat.

Par exemple, pour la structure de test, on peut choisir une forme en C, en "n", en C inversé au lieu de la forme en U.

Bien entendu, l'invention s'applique à la réalisation de tous niveaux connectés électriquement et dont les surfaces de connexion peuvent varier en fonction des décalages inhérents aux étapes de réalisation. Par exemple, on peut réaliser des connexions entre deux niveaux très proches entre lesquels les vias sont réduits à de simples surfaces de contact. Ce procédé est typiquement utilisé pour les interconnexions locales.

## Revendications

1. Portion de circuit intégré comprenant une pluralité de niveaux de métallisation séparés par des couches diélectriques, chaque niveau de métallisation étant pourvu de pistes (20), et des moyens de connexion connectant des pistes de deux niveaux de métallisation inférieur et supérieur, **caractérisée par le fait** que toute portion de piste connectée aux moyens de connexion s'étend dans une direction unique pour un niveau donné de métallisation sur une distance prédéterminée à partir de la connexion.

2. Portion de circuit intégré selon la revendication 1, caractérisée par le fait que les moyens de connexion comprennent des vias.

3. Portion de circuit selon la revendication 2, caractérisée par le fait que la distance prédéterminée minimale est sensiblement égale à la somme de la largeur d'un via et du décalage maximal entre les pistes et les vias, la largeur étant prise dans un plan parallèle aux plans des niveaux de métallisation.

4. Portion de circuit selon la revendication 2 ou 3, caractérisée par le fait que toute portion de piste (21) connectée à un via s'étend dans un sens unique pour un niveau donné de métallisation de façon à ce qu'un éventuel défaut d'alignement entre les pistes d'un niveau de métallisation et les vias connectées aux dites pistes produise une modification constante de la résistance existant entre une piste et un via sur tout ledit niveau de métallisation.

5. Portion de circuit selon l'une quelconque des revendications précédentes, caractérisée par le fait que seulement les extrémités des pistes sont orientées.

6. Portion de circuit selon l'une quelconque des revendications 2 à 4, caractérisée par le fait que la largeur d'une piste est inférieure ou égale à la somme de la largeur d'un via et du décalage maximal entre les pistes et les vias.

7. Portion de circuit selon la revendication 6, caractérisée par le fait que la largeur d'une piste est égale à la largeur d'un via.

8. Structure de test comportant une portion de circuit selon l'une quelconque des revendications précédentes.

9. Circuit intégré comprenant une structure de test selon la revendication 8.

10. Circuit intégré comportant une portion de circuit selon l'une quelconque des revendications 1 à 7.
